# EUROPÄISCHE PATENTSCHRIFT

(11) **EP 0 994 777 B1**
(45) Veröffentlichungstag und Bekanntmachung des Hinweises auf die Patenterteilung: **15.01.2003**
(21) Anmeldenummer: 98943702.5
(22) Anmeldetag: 10.07.1998
(51) Int. Cl.: B32B 31/00, B32B 18/00, B32B 15/01

(54) **VERFAHREN ZUM HERSTELLEN EINES METALLISCHEN ODER KERAMISCHEN KÖRPERS**
METHOD FOR PRODUCING A METALLIC OR CERAMIC BODY
PROCEDE POUR PRODUIRE UN CORPS METALLIQUE OU CERAMIQUE

(30) Priorität: 11.07.1997 DE 19729770
(43) Veröffentlichungstag der Anmeldung: 26.04.2000
(73) Patentinhaber: Graf, Daniel, 71254 Heimerdingen (DE)
(72) Erfinder: Graf, Daniel, 71254 Heimerdingen (DE)
(74) Vertreter: Goy, Wolfgang, Dipl.-Phys.
(86) Internationale Anmeldenummer: DE9801977
(87) Internationale Veröffentlichungsnummer: WO99002342

(56) Entgegenhaltungen:
- EP-A- 0 738 583
- WO-A-97/40983

## Beschreibung

Die Erfindung betrifft ein Verfahren zum Herstellen eines metallischen oder keramischen Körpers nach dem Oberbegriff des Anspruchs 1.

Das erfindungsgemäße Herstellungsverfahren ist allgemein für die Erzeugung beliebiger metallischer oder keramischer Körper gedacht. Ein spezielles Anwendungsgebiet ist das Herstellen von Werkzeugen sowie Prototypformen. Der Zweck dieses erfindungsgemäßen Verfahrens liegt in der schnellen Herstellung der Metallkörper.

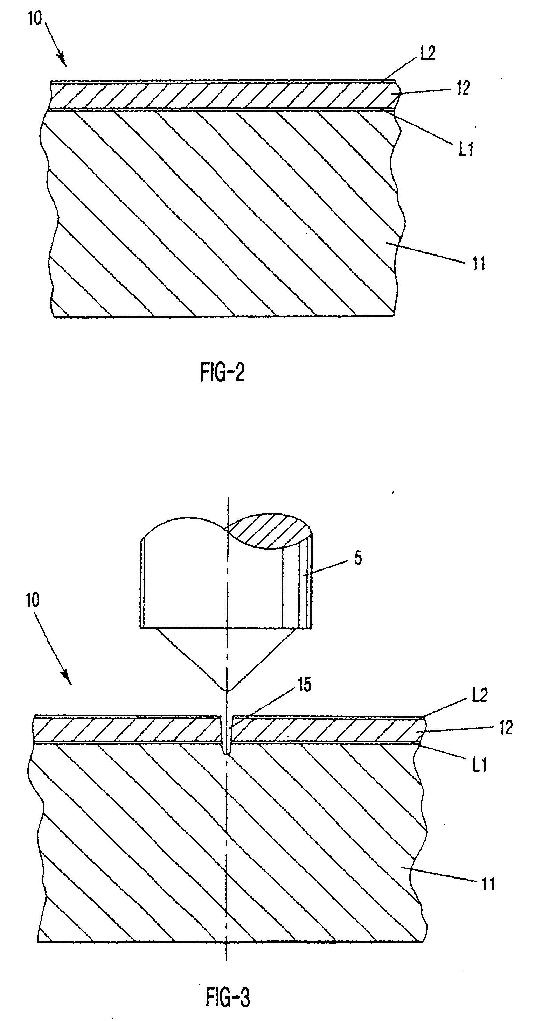

Aus der WO-A-9740983 ist ein Verfahren sowie eine Vorrichtung zum automatischen Herstellen von dreidimensionalen Körpern der eingangs angegebenen Art bekannt. Dabei wird der Körper gemäß der relevanten Ausführungsform der Fig. 3B sowie Fig. 3C aus flächigen Körperelementen schichtweise aufgebaut. Es wird dabei von einem Grundmaterial ausgegangen. Dieses Grundmaterial weist ein Trägermaterial mit darauf aufgebrachtem Körpermaterial auf, wobei das Körpermaterial mittels einer Klebeschicht auf dem Trägermaterial aufgeklebt ist. Zur Herstellung des Körpers werden zunächst flächige Körperelemente aus dem Körpermaterial des Grundmaterials ausgeschnitten. Weil die zuletzt aufgebrachte Schicht an ihrer Unterseite (noch) eine Klebeschicht aufweist, kann die Oberseite des Körperelements mit dieser Unterseite der Klebeschicht der zuletzt aufgebrachten Schicht verbunden werden. Anschließend wird das Trägermaterial von der Klebeschicht entfernt, wobei die Klebeschicht am Körperelement haften bleibt, so daß - wie oben beschreiben - die nächste Schicht befestigt werden kann. - Der Nachteil dieses bekannten Grundmaterials mit dem dazugehörigen Herstellungsverfahren besteht darin, daß die Klebeschicht sowohl dazu dient, das Trägermaterial zu halten, als auch nach dem Ablösen des Trägermaterials die Aufgabe hat, die nächste Schicht mit dem Körperelement zu fixieren. Sollte beim Ablösen des Trägermaterials eine Beschädigung dieser Klebeschicht auftreten, so hat dies zwangsläufig zur Folge, daß das als nächstes anzubringende Körperelement nicht 100%-ig verbunden ist.

Davon ausgehend liegt der Erfindung die **Aufgabe** zugrunde, das Verfahren zum Herstellen eines metallischen oder keramischen Körpers der eingangs angegebenen Art derart weiterzuentwickeln, daß eine einwandfreie Verbindung des Körperelements mit der zuletzt aufgebrachten Schicht sichergestellt sowie der Ablöseprozeß zwischen Körperelement und Trägermaterial verbessert ist.

Die technische **Lösung** ist gekennzeichnet durch die Merkmale im Kennzeichen des Anspruchs 1.

Die Grundidee des erfindungsgemäßen Verfahrens zum Herstellen eines metallischen oder keramischen Körpers besteht darin, daß das Körpermaterial des Grundmaterials (aus welchem die Körperelemente ausgeschnitten werden), zwei Verbindungsbeschichtungen aufweist, nämlich eine erste Beschichtung auf der Unterseite des Körpermaterials / Körperelements, mittels welcher das Trägermaterial lösbar verbunden ist, sowie eine zweite Beschichtung auf der Oberseite des Körpermaterials / Körperelements, mittels welcher die Verbindung mit der zuletzt aufgebrachten Schicht des Körpers hergestellt wird. Diese beiden voneinander unabhängigen Verbindungsbeschichtungen haben den Vorteil, daß sie sich nicht negativ gegenseitig beeinflussen können, so daß optimale Bedingungen für die beiden Verbindungen bestehen.

Dieses Herstellungsverfahren ist vor allem für sehr filigrane Konturabmessungen (beispielsweise Kreise mit einem Durchmesser von 1 mm), deren Fixierung beim Schneiden, Transport und Aufbau sehr schwierig ist, von großer Bedeutung. Dadurch können metallische Körper, insbesondere Werkzeuge sowie Prototypformen mit sehr großer Detailgenauigkeit hergestellt werden, da mittels des erfindungsgemäßen Verfahrens flächige Körperelemente mit einer sehr geringen Schichtdicke von 0,01 bis 0,05 mm verarbeitet werden können. Dadurch kann eine sehr gute Konturgenauigkeit erreicht werden. So können beispielsweise auch kleine Radien noch sauber abgebildet werden. Die Grundidee des erfindungsgemäßen Herstellungsverfahrens besteht dabei darin, das flächige Körperelement nicht für sich alleine zu handhaben, sondern es auf einem stabilen Trägermaterial anzuordnen, welches beispielsweise eine Dicke von 0,1 bis 1,0 mm haben kann und selbst aus Metall besteht. Das flächige Körperelement ist dabei zum Zwecke des späteren Ablösens gewissermaßen provisorisch auf dem Trägermaterial lösbar befestigt. Durch dieses stabilisierende Trägermaterial können die zuvor bereits erwähnten sehr dünnen flächigen Körperelemente gehandhabt werden. Weiterhin besteht auch die Möglichkeit, Hohlkörper und Hinterschnitte in dem metallischen Körper zu erzeugen. Die erzeugten metallischen Körper bestehen dabei nicht aus einem Werkstoffgemisch, sondern zu über 90 % aus dem Grundwerkstoff, nämlich dem Material der flächigen Körperelemente. Das Trägermaterial dient darüber hinaus zur positionsgenauen Fixierung und dem Transport der erzeugten flächigen Körperelemente bis hin zum Aufbau der Geometrie. Somit können Werkzeuge sowie Metall-Prototypteile aus beliebigen metallischen Werkstoffen mit hoher Genauigkeit und Schnelligkeit auch bei großen Abmessungen sowie kleinen Details erzeugt werden. Dabei sind sehr hohe mechanische und thermische Belastbarkeiten sowie eine gute Wärmeleitfähigkeit gegeben. Durch das erfindungsgemäße Verfahren entstehen vollständig metallische Körper. Zur Herstellung der Bauteile können alle gewöhnlichen Metallwerkstoffe verwendet werden (z.B. Stahl, Edelstahl, Aluminium, Kupfer, Messing). Durch die Vielfalt der verwendbaren Werkstoffe bietet sich das Verfahren nicht nur zur Herstellung von Prototypformen (oder Werkzeugen) für den Thermoplastspritzguß, die Duroplastverarbeitung oder den Aluminiumdruckguß, sondern allgemein zur Herstellung metallischer Prototypen sowie komplexer metallischen Strukturen an. Durch das Vorliegen eines kompakten Metallwerkstoffs ist eine gute Wärmeleitfähigkeit gegeben. Dadurch können in der Prototypform (z.B. bei Thermoplastspritzguß) seriennahe Fertigungsbedingungen erreicht werden. Das ist vor allem für die Fertigung von technischen Funktionsmuster von hohem Interesse (sonst können sich z.B. die mech. Eigenschaften der Prototypenteile zu den Serienteilen unterscheiden). Ein weiterer Vorteil liegt darin, daß die erzeugten Werkzeuge einer hohen thermischen Belastung standhalten. Dadurch kann das Verfahren zur Herstellung von Prototypformen sowohl für den Thermoplastspritzguß als auch für die Duroplastverarbeitung sowie für Aluminiumdruckguß, Zinkdruckguß und andere Metallgußverfahren verwendet werden. Durch die freie Werkstoffauswahl sowie die Herstellung vollmetallischer Körper ist eine hohe mechanische Belastbarkeit der Werkzeuge/Bauteile für den jeweiligen Einsatzzweck gegeben. Dadurch können bei Spritzformen hohe Standzeiten erreicht werden. Die entstandenen Werkzeuge sind über das Prototypstadium hinaus auch für den Vorserien- und Serieneinsatz nutzbar. Aufgrund dieser Gegebenheit können erhebliche Kosteneinsparungen für den Bau von Serienwerkzeugen erreicht werden. In der Gesamtentwicklung eines Produktes führt jedoch der Wegfall der Bauzeit für das Serienwerkzeug zu erheblichen Zeiteinsparungen und Verkürzung der Entwicklungszeiten. Bei der Herstellung entsteht keine Schwindung, die bei der Werkzeugauslegung berücksichtigt werden müßte. Dadurch wird die Erzeugung bzw. Aufbereitung der CAD-Daten vereinfachtund die Genauigkeit der Bauteile wesentlich verbessert. Der Herstellungsprozeß ist einfach und schnell. Kern und Kavität eines Werkzeuges können in einem Arbeitsschritt hergestellt werden. Dadurch wird die nominale Fertigungdauer gegenüber den oben beschriebenen Verfahren halbiert. Die Herstellungsdauer - selbst großer Werkzeuge (z.B. 600mm x 400mm x 200mm) - beträgt 1 maximal jedoch 2 Tage. Bei kleinen bis mittleren Werkzeugen (250mm x 250mm x 150mm) ist eine Herstellung innerhalb weniger Stunden (3 - 10 Stunden) möglich. Es können problemlos große Werkzeugabmessungen (1000mm x 1000mm x 500mm und größer) realisiert werden. Bei kleineren Werkzeugen können, auf einer Anlage, auch mehrere Werkzeuge gleichzeitig hergestellt werden. Die Anlagen arbeiten vollautomatisch. Daher ist eine tägliche Nutzungsdauer von 24 h möglich. Bei nachträglichen Änderungen an den Bauteilen oder Werkzeugen können alle üblichen Metallbearbeitungsverfahren eingesetzt werden (z.B. Bohren, Drehen, Fräsen, Schleifen, Erodieren etc.). Zur Herstellung der Werkzeuge und Bauteile kann - wie bereits ausgeführt - mit einer sehr geringen Schichtdicke (0,01 mm - 0,05 mm) gearbeitet werden. Dadurch kann eine sehr gute Konturgenauigkeit erreicht werden (es können z.B. auch kleine Radien noch sauber abgebildet werden).

Eine erste Variante der Verfahrensdurchführung schlägt die Weiterbildung gemäß Anspruch 2 vor. Die Grundidee liegt in einem 4-Schicht-System, wobei die erste Lotschicht dazu dient, die feste Verbindung des flächigen Körperelements mit dem bis zu diesem Zeitpunkt bereits erstellten metallischen Körper herzustellen, während die zweite, niedrigschmelzende Lotschicht lediglich die Aufgabe hat, das flächige Körperelement am Trägermaterial für den Schneidvorgang sowie Transport zu fixieren. Als niedrigschmelzendes Lot kann beispielsweise Bronze und als hochschmelzendes Lot beispielsweise Kupfer verwendet werden. Durch die Erwärmung des Systems bis über die Schmelztemperatur der ersten Lotschicht hinaus wird die Voraussetzung dafür geschaffen, daß das zu befestigende flächige Körperelement eine feste Verbindung mit dem Körper eingehen kann. Durch das Abkühlen auf den Temperaturzwischenbereich zwischen den beiden Schmelztemperaturen härtet diese hochschmelzende Lotschicht aus, so daß die Verbindung zwischen dem flächigen Körperelement und dem Körper derart fest ist, daß das so befestigte flächige Körperelement von dem Trägermaterial abgelöst werden kann. Da die Lotschichten eine bezüglich der metalischen Körperelemente sehr ähnliche Zusammensetzungen aufweisen, ist die "Verunreinigung" nur gering.

Eine Alternative zu dem vorbeschriebenen Lotverfahren schlägt die Weiterbildung gemäß Anspruch 3 vor. Auch hier handelt es sich um ein Mehr-Schicht-System, insbesondere um ein 4-Schicht-System, bei dem als Mehr-Komponenten-Kleber beispielsweise ein Epoxidharz verwendet werden kann. Hierbei handelt es sich um ein Low-Cost-Verfahren. Da das zuvor beschriebene Verfahren infolge des Lotvorganges mit einem relativ hohen maschinellen und prozeßtechnischen Aufwand verbunden ist und weiterhin durch diesen Prozeß Stahlformen mit den mechanischen Eigenschaften einer Serienform erzeugt werden können, ist die erste Alternative aufwendig und daher - von den Kosten - höher als dieses vereinfachte - und damit preiswertere - Verfahren. Die Grundidee besteht dabei darin, daß die einzelnen Schichten durch Verkleben miteinander verbunden werden. Der Klebeprozeß läuft dabei vorzugsweise bei einer erhöhten Temperatur ab. Diese Temperatur befindet sich jedoch deutlich unter den Lottemperaturen, so daß der Prozeßaufwand wesentlich geringer ist. Die durch den Klebeprozeß erzeugten Körper dienen im wesentlichen der Verwendung als Prototypformen, da sie geringere mechanische Eigenschaften aufweisen. Die erreichbaren Festigkeiten erlauben jedoch, mehrere hundert bzw. tausend Teile in einem Prototypwerkzeug zu spritzen. Die beiden Kleberkomponenten haben im Ausgangszustand eine gewisse Klebneigung, so daß das flächige Körperelement durch die erste Komponente relativ fest mit dem Trägermaterial verbunden ist. Die eigentliche Klebefestigkeit wird jedoch erst dann erreicht, wenn die erste Komponente mit der zweiten Komponente in Berührung kommt. Durch das Ablösen vom Trägermaterial befindet sich auf der Unterseite der bereits aufgebauten Geometrie die erste Kleberkomponente als Restbestandteil. Durch Anpressen einer neuen Schicht, auf deren Oberseite die zweite Komponente vorhanden ist, kann dann eine chemische Reaktion der beiden Komponenten stattfinden, wodurch eine fest Verbindung zwischen bereits existierender Geometrie und neuer Schicht erreicht wird. Dadurch wird ein Ablösen der gerade aufgebrachten Schicht vom Trägermaterial möglich, da die chemisch ausreagierten Kleberkomponenten eine wesentlich höhere Festigkeit haben als die erste Komponente. Der gesamte Prozeß wird durch eine erhöhte Temperatur unterstützt, die jedoch nur zeitweise, d.h. während des Reaktionsprozesses der beiden Komponenten sowie zum Ablösen der Folien vom Trägermaterial wirkt. Durch die erhöhte Temperatur verringert sich die Klebeneigung der ersten Komponente am Trägermaterial, so daß das Ablösen des flächigen Körperelements vom Trägermaterial erleichtert wird. Durch die erhöhte Temperatur wird weiterhin die Klebereaktion, nämlich der Aushärteprozeß beschleunigt. Die Temperaturaufprägung kann durch eine beheizbare Platte (Tisch) erfolgen, die nur zeitweise aktiv ist. Die gleiche Art der Temperaturaufprägung kann bei dem zuvor erwähnten Lotvorgang durchgeführt werden.

Wie zuvor bereits erwähnt, besteht eine vorteilhafte Weiterbildung dieser zweiten Alternative in der Verfahrensdurchführung darin, daß gemäß Anspruch 4 zusätzlich Wärme zugeführt wird. Die Vorteile sind bereits beschrieben worden.

Gemäß der Weiterbildung in Anspruch 5 können - abhängig von der Kontur - homogene Bereiche mit größerer Schichtdicke aufgebaut werden, was eine große Zeitersparnis mit sich bringen kann. Bereiche mit starker Konturänderung werden dagegen mit sehr dünnen Schichten für die Konturerfassung versehen.

Das Laser-Gravieren gemäß der Weiterbildung in Anspruch 6 stellt eine einfache Möglichkeit zum Ausschneiden der Körperelemente dar. Durch die maschinenbaulichen Gegebenheiten der Lasertechnik kann eine sehr hohe Geometriegenauigkeit erzielt werden. Auch filigrane Geometriedetails können erfaßt und abgebildet werden, beispielsweise dünne Rippen, Dome sowie Stege. Bezüglich der mechanischen Festigkeit stellen solche Details kein Problem dar. Durch das Laser-Gravieren wird der jeweilige Konturverlauf der benötigten Geometrieschicht in das Grundmaterial eingraviert. Die Graviertiefe reicht dabei bis in das Trägermaterial (d.h. insgesamt ca. 60 bis 70 µm tief. Dadurch ist die saubere Durchtrennung gewährleistet. Zur Erzielung einer möglichst hohen Bearbeitungsgeschwindigkeit durch den Laser bietet sich darüber hinaus ein Doppel- oder Mehrfach-Lasereinsatz an. Durch den ersten Laser wird beispielsweise die Kernkontur eingraviert. Anschließend wird das Band um einen entsprechenden Weg vorwärts bewegt. Die Kavitätskontur wird durch einen zweiten Laser eingebracht, während der erste Laser bereits wieder die nächste Kernkontur bearbeitet. Durch die Verwendung mehrerer Laser kann die Bearbeitungsgeschwindigkeit weiter gesteigert werden. Durch diese Hintereinander- bzw. Parallelschaltung mehrerer Laser kann eine Steigerung der Bearbeitungsgeschwindigkeit bzw. die Bearbeitung mehrerer Werkstücke gleichzeitig erreicht werden.

Eine weitere Weiterbildung des erfindungsgemäßen Herstellungsverfahrens schlägt Anspruch 7 vor. Das Grundproblem besteht nämlich darin, daß die erste benötigte Konturschicht nicht direkt in das Grundmaterial eingebracht werden kann, da noch kein "Abdruckstempel" (Bauteil, Kern, Kavität) besteht, der die nötige Geometrieinformation zum Aufnehmen der gavierten Konturschicht aus dem Grundmaterial besitzt. Einfach ausgedrückt: Die Abdruckfläche für den Körper ragt über die Umfangskontur des ersten flächigen Körperelements hinaus und würde dadurch eine unerwünschte Verbindung mit dem Körpermaterial außerhalb des gravierten flächigen Körperelements herstellen. Zur Realisierung dieses ersten flächigen Körperelements kann ein separates Grundmaterial verwendet werden, welches nur aus dem Körpermaterial sowie beispielsweise einem hochschmelzenden Lot als Verbindungsmaterial besteht. Durch den Laser wird das zusätzliche Band zunächst konturgerecht mit dem (Haupt-)Band, d.h. dem Grundmaterial zur Fixierung verlötet, nachdem zuvor das (Haupt-)Band entsprechend graviert worden ist. Anschließend wird aus dem (Hilfs-)Band die erste Konturschicht ausgeschnitten. Durch diesen Vorgang ist das (Haupt-)Band im Bereich der gewünschten Kontur überstehend und kann von einer ebenen Platte vom Trägermaterial abgelöst werden. Bevor somit die erste Konturschicht durch das (Hilfs-)Band auf das (Haupt-)Band aufgebracht wird, wird zunächst im (Haupt-)Band die zweite Konturschicht eingebracht. Dieser Vorgang ist notwendig, um die Ablösung der ersten beiden Schichten vom Trägermaterial zu ermöglichen. Außer bei der Aufbringung des ersten flächigen Körperelements ist der Einsatz dieser Technik immer dann notwendig, wenn eine Konturänderung parallel zur Ebene der zuletzt aufgebrachten Schicht erfolgt, da - wie ausgeführt - bei einer solchen Konturänderung die nötige Abdruckinformation am Stempel nicht vorliegt.

Eine Alternative (oder zusätzliche) Weiterbildung zur Lösung der vorbeschriebenen Problematik schlägt Anspruch 8 vor. Dadurch wird einem Kontursprung um 90° sowie einer notwendigen Erweiterung des Gravurspaltes abhängig vom Geometriegradienten des zu erzeugenden Körpers Rechnung getragen. Denn auch hier besteht das Problem darin, daß das Ablösen des gewünschten Foliensegments vom Trägermaterial nicht möglich ist, da der Querschnitt des bereits erstellten Körpers hinsichtlich seines realen Überdeckungsbereiches beim Anpressen zu groß ist. Indem aber eine Oberflächenabtragung durchgeführt wird, kommt der bereits erzeugte Körper gar nicht in Kontakt mit der (abgetragenen) Oberfläche. Dieser Überdekungsbereich kann durch sogenanntes Wobbeln mit einem Laserstrahl abgetragen werden. Somit wird die Verbindung mit den ausschließlich benötigten Stellen der Folie des flächigen Körperelements möglich. Die gleiche Problematik des Kontursprunges tritt auch bei bestimmten Geometriegradienten auf. Da der Gravurspalt relativ schmal ist, ist es notwendig, den Gravurspalt ab einem bestimmten Konturwinkel zu verbreitern. Um möglichst wirtschaftlich arbeiten zu können, wird die Gravurspaltverbreiterung auf das jeweils von der Kontur abhängige Maß beschränkt. Diese Gravurspalterweiterung kann ebenfalls durch Wobbeln erreicht werden. Die Breite des Gravurspaltes wird somit als Funktion des Konturwinkels erzeugt, um so nur eine minimale Breite erzeugen zu müssen, mittels der gerade ein sauberer Geometrieaufbau möglich ist und keine unzulässigen Überdeckungen entstehen.

Eine weitere Weiterbildung des erfindungsgemäßen Herstellungsverfahrens schlägt gemäß Anspruch 9 vor, daß das Grundmaterial als von einer Vorratsrolle abwickelbares Bandmaterial ausgebildet ist.

Alternativ kann gemäß Anspruch 10 das Grundmaterial auch als Einzelplatte ausgebildet sein, wobei sich vom Verfahrensablauf her nichts ändert. Die Zuführung des Grundmaterials als Plattenware hat die Vorteile, daß ein Materialwechsel schnell und einfach durchgeführt werden kann und daß unterschiedliche Schichtdicken zum Aufbau der Geometrie verwendet werden können. Die Platten werden während der Laserbearbeitung durch eine seitliche Fixierung gehalten. Der Transport der Platten erfolgt über ein Rollensystem. Die Rollen werden dabei zur Bearbeitung der Platten in dem Tisch versenkt, so daß eine flächige Auflage der Platte gegeben ist. Auch während des Lotvorganges erfolgt eine seitliche Fixierung der Platten. Die Platten können aus einem Magazin der Anlage zugeführt und nach der Bearbeitung durch ein Greifersystem wieder entnommen werden.

Ein Ausführungsbeispiel einer Anlage zum erfindungsgemäßen Herstellen eines metallischen Körpers wird nachfolgend anhand der Zeichnungen beschrieben. In diesen zeigt:

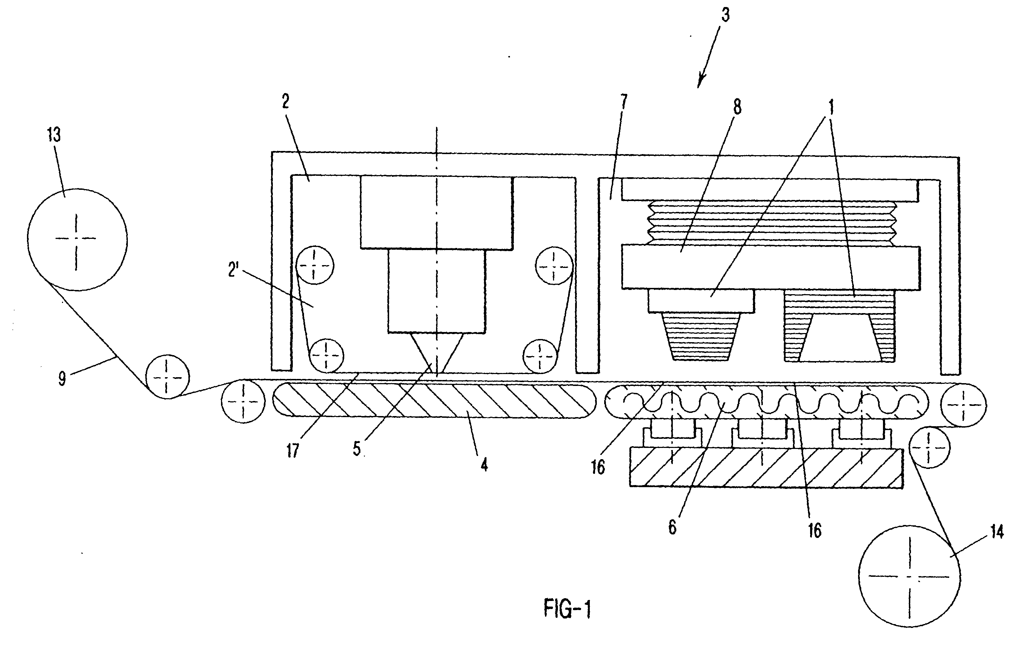

- Fig. 1: eine schematische Seitenansicht der Anlage;
- Fig. 2: einen Schnitt durch das Grundmaterial im Ausgangszustand;
- Fig. 3: eine Darstellung entsprechend der in Fig. 2, jedoch mit dem Laser-Gravierprozeß;
- Fig. 4: eine Darstellung entsprechend der in den Fig. 2 und 3 im Bereich eines ausgeschnittenen Körperelements mit darüber befindlichem, bereits erstellten Körper;
- Fig. 5: eine Darstellung entsprechend der in Fig. 4, jedoch mit einer teilweise entfernten Oberseite des Körpermaterials;
- Fig. 6: eine Darstellung entsprechend der in Fig. 4, jedoch mit einer etwas anderen Form des bereits erstellten Körpers;
- Fig. 7: eine Darstellung entsprechend der in Fig. 2, jedoch mit Komponenten eines 2-Komponenten-Klebers;
- Fig. 8: eine Darstellung basierend auf der Darstellung in Fig. 7 beim Befestigen einer Folie mittels des 2-Komponenten-Klebers;
- Fig. 9: eine Draufsicht auf eine bearbeitete Folie zur Verdeutlichung des Mehrfach-Lasereinsatzes.

Die Anlage zum Herstellen beliebiger metallischer Körper 1 besteht aus einer Ausschneidestation 2 sowie aus einer nachfolgenden Befestigungsstation 3. Dabei ist der Ausschneidestation eine Zusatzbandanlage 2' zugeordnet, welche in die Ausschneidestation 2 bedarfsweise eingefahren werden kann.

Die Ausschneidestation weist einen Auflagetisch 4 sowie darüber einen Laser-Gravierer 5 auf.

Die Befestigungsstation 3 weist ebenfalls einen beheizbaren sowie darüber hinaus einen höhenverstellbaren Auflagetisch 6 auf. Darüber befindet sich ein Lotofen 7, in dem höhenverstellbar eine Träger 8 für die herzustellenden metallischen Körper 1 angeordnet ist.

Der Anlage zugeorndet ist ein Band 9 aus einem Grundmaterial 10, welches in Fig. 2 größer dargestellt ist. Dieses Grundmaterial 10 weist zunächst ein Trägermaterial 11 aus einem Metallband mit einer Dicke von 0,1 bis 1,0 mm auf. Mittels einer ersten, niedrigschmelzenden Lotschicht L1 ist ein metallisches Körpermaterial 12 mit einer Dicke von 0,01 bis 0,05 mm befestigt. Auf dem Körpermaterial 12 befindet sich eine zweite, hochschmelzende Lotschicht L2. Die Lotschicht L1 kann aus Bronze und die Lotschicht L2 aus Kupfer bestehen, während es sich bei dem Metall für das Körpermaterial 12 um dasjenige Metall handelt, aus dem der metallische Körper 1 hergestellt werden soll.

Das Herstellungsverfahren für den metallischen Körper 1 funktioniert wie folgt:

Das Band 9 ist auf einer Vorratsrolle 13 aufgerollt und über Umlenkrollen durch die Anlage hindurchgeführt, wonach das Band dann auf einer weiteren Rolle 14 aufgewickelt wird. Das Band 9 durchläuft zunächst die Ausschneidestation 2. Sofem bereits ein Teil des metallischen Körpers 1 erstellt worden ist, ist die Zusatzbandanlage 2' ausgefahren. Mittels des Laser-Gravierers 5 wird in das Grundmaterial 10 der jeweilige Konturverlauf der hier benötigten Geometrieschicht eingraviert. Dies ist in Fig. 3 dargestellt. Die Graviertiefe reicht bis in das Trägermaterial 11, d.h. insgesamt ca. 60 bis 70 µm tief. Dadurch ist die saubere Durchtrennung des Körpermaterials 12 gegeben. Der Schnitt 15 der Gravierlinie begrenzt das jeweils benötigte dünne sowie flächige Körperelement 16.

Nach dem Gravierprozeß wird das Band 9 weitertransportiert, so daß das Körperelement 16 positioniert in der Befestigungsstation 3 zu liegen kommt. Hier erfolgt der Aufbau der eigentlichen Geometrie mit dem anschließenden Lotvorgang. Das Grundprinzip besteht dabei darin, daß der Aufbau und die Erzeugung der Geometrie durch viele sehr dünne Schichten mittels der Körperelemente 16 erfolgt, bei denen die jeweilige Schicht die Kontur des Bauteils an dieser Stelle nachbildet. Durch die Fixierung der Schichten können sehr filigrane Konturabmessungen, beispielsweise Kreise mit einem Durchmesser von 1 mm realisiert werden. Das Band 9 wird positionsgenau unter den Abdruckstempel des Trägers 8 gebracht. Für die genaue Positionierung des Bandes 9 unter dem Abdruckstempel ist seitlich am Band 9 eine Wegmeßsensorik angebracht, die diesen Vorgang steuert und überwacht.

Nach der Positionierung liegt das Band 9 mit dem geschnittenen Körperelement 16 auf eine auf dem vertikal beweglichen Auflagetisch 6 im Lotofen 7. Im Lotofen herrscht eine gewisse Grundtemperatur, die unterhalb der Schmelztemperatur des niedrigschmelzenden Lotes L1 liegt. Zur Durchführung des eigentlichen Lotvorganges ist der Auflagetisch 6 elektrisch beheizbar und kann innerhalb sehr kurzer Zeit die Schmelztemperatur des hochschmelzenden Lotes L2 erreichen.

Der Auflagetisch 6 wird nach oben bzw. der Träger 8 nach unten bewegt, wodurch es zu einer Anpressung des Körperelements 16 an den bereits erstellten metallischen Körper 1 kommt. Anschließend erfolgt die elektrische Aufheizung des Auflagetisches 6, was zu Erwärmung des Grundmaterials auf Schmelztemperatur des hochschmelzenden Lotes L2 führt. Dadurch erfolgt der Lotvorgang zwischen dem gravierten Körperelement 16 und dem metallischen Körper 1, bei dem durch die vorliegende Flächenpressung eventuell überschüssiges Lot aus der Verbindungsstelle gedrückt wird. Anschließend erfolgt ein gezielter Abkühlvorgang, bei dem der Auflagetisch 6 kurz vor Erreichen der Erstarrungstemperatur des niedrigschmelzenden Lotes L2 nach unten fährt bzw. der Träger 8 nach oben gefahren wird. Die hochschmelzende Lotschicht L2 ist zu diesem Zeitpunkt bereits erstarrt und hat eine feste Verbindung mit dem metallischen Körper 1 eingegangen. Durch ein Abwärtsbewegen des Auflagetisches 6 und Aufwärtsbewegen des Trägers 8 löst sich das Trägermaterial 11 an der niedrigschmelzenden Lotschicht L1 vom Körperelement 16. Das Trägermaterial 11 wird dabei seitlich am Tisch geführt, so daß ein sauberes Ablösen der Schicht möglich ist. Der Ablösevorgang wird zusätzlich durch die Schwerkraft unterstützt.

Das erste benötigte Körperelement 16 kann nicht direkt in das Grundmaterial 10 eingebracht werden, da noch kein "Abdruckstempel" (Bauteil, Kern, Kavität) besteht, der die nötige Geometrieinformation zum Aufnehmen des gravierten Konturschicht aus dem Grundmaterial 10 besitzt. Zur Erzeugung dieses ersten Körperelements 16 wird somit die Zusatzbandanlage 2' verwendet, welche horizontal verfahrbar zur Erzeugung dieser ersten Schicht eingefahren wird. Das dort verwendete Band 17 besteht dabei aus einem Körpermaterial 12 und einer hochschmelzenden Lotschicht. Durch den Laser wird das Band 17 zunächst konturgerecht mit dem Band 9 zur Fixierung verlötet, und anschließend wird aus dem Band 17 des erste Körperelement 16 ausgeschnitten. Durch diesen Vorgang wird das Band 9 im Bereich der gewünschten Kontur erhaben und kann von einer ebenen Platte des Trägers 8 aufgenommen werden. Bevor jedoch die erste Konturschicht durch das Band 17 auf das Band 9 aufgebracht wird, wird zunächst im Band 9 die zweite Konturschicht eingebracht. Dieser Vorgang ist notwendig, um die Ablösung der ersten beiden Schichten vom Trägermaterial 11 zu ermöglichen.

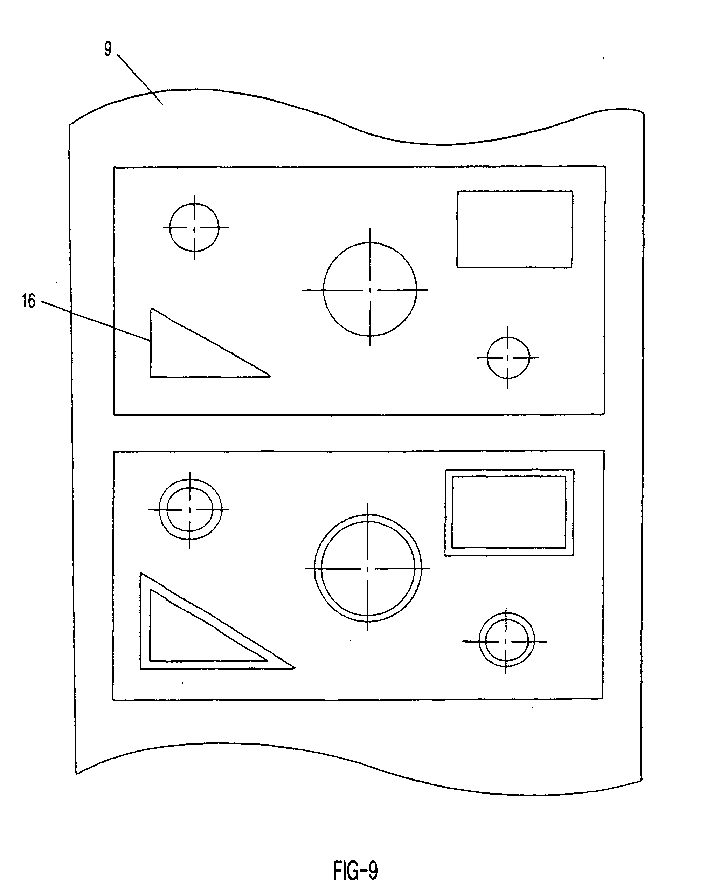

Der Einsatz dieser Zusatzbandanlage 2' ist immer bei einer Konturänderung notwendig, welche parallel zum Träger 8 verläuft, da bei einer solchen Konturänderung die nötige Abdrukkinformation am Stempel nicht vorliegt. Zur Erzielung einer möglichst hohen Bearbeitungsgeschwindigkeit durch den Laser bietet sich ein Mehrfach-Lasereinsatz an, welcher in Fig. 9 dargestellt ist. Durch den ersten Laser wird beispielsweise die Kernkontur in das Band eingraviert. Danach wird das Band um einen entsprechenden Weg vorwärtsbewegt. Die Kavitätskontur wird durch den zweiten Laser eingebracht (in Fig. 9 unten), während der erste Laser bereits wieder die nächste Kontur bearbeitet. Durch die Verwendung mehrerer Laser kann die Bearbeitungsgeschwindigkeit weiter gesteigert werden.

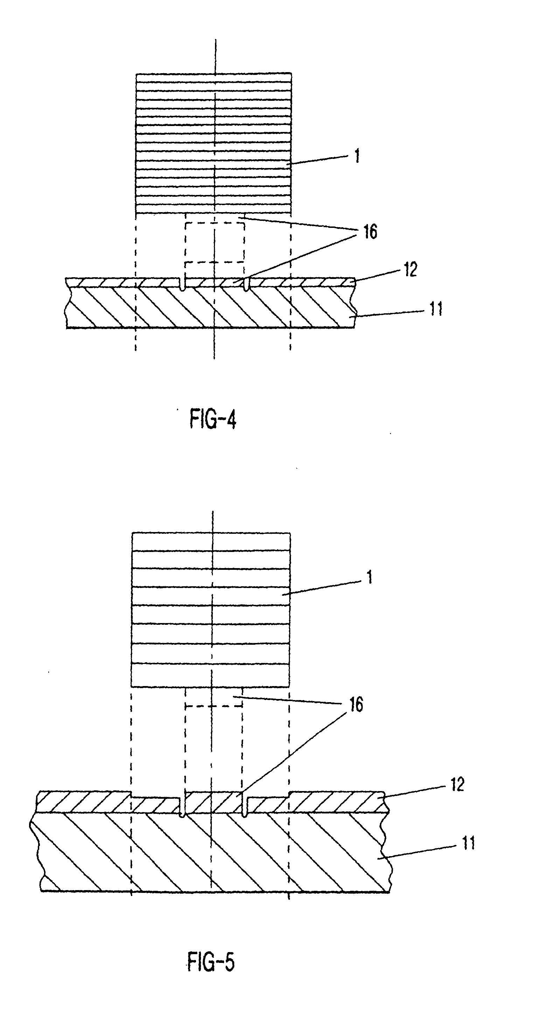

Bei dem Ausführungsbeispiel in den Fig. 4 und 5 besteht das Problem, daß als weitere Schicht ein Körperelement 16 befestigt werden soll, welches bezüglich des bereits erstellten metallischen Körpers 1 einen Kontursprung um 90° darstellt. Dies würde bedeuten, daß die unterste Schicht des Körpers 1 nach entsprechender Gravur bis über die Schnittstelle des Körperelements 16 hinausragt und somit bei dem Lötvorgang mit diesem unerwünschten Außenbereich verlötet würde. Aus diesem Grunde wird die Oberfläche des Körpermaterials 12 in diesem Bereich mittels Laser getragen. Dies ist in Fig. 5 erkennbar.

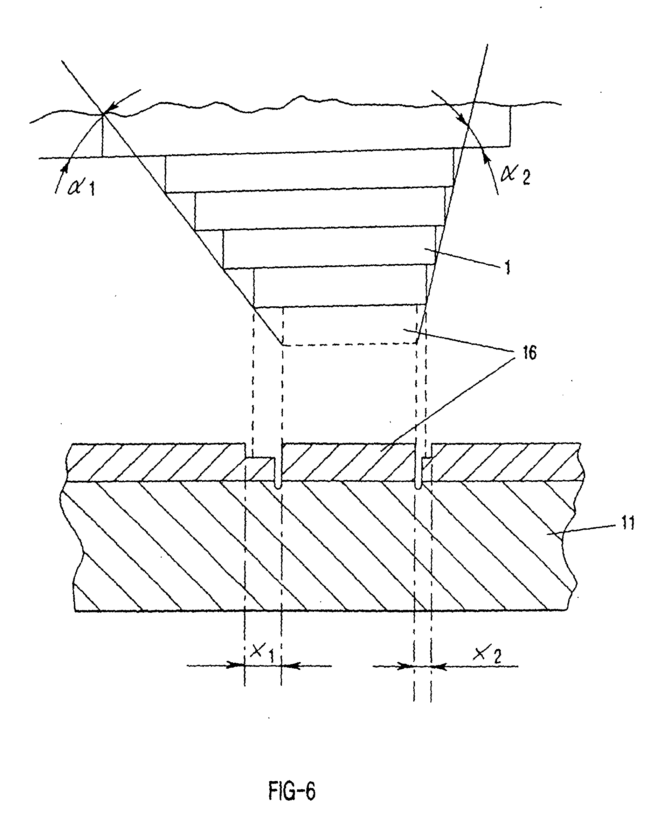

Ein ähnliches Problem ist in Fig. 6 dargestellt. Aufgrund des Winkelgradienten des metallischen Körpers 1 würde eine Überlappung mit dem Außenbereich des Körpermaterials 12 erfolgen. Auch hier wird entsprechend dem Winkelgradienten eine Abtragung des Körpermaterials 12 vorgenommen.

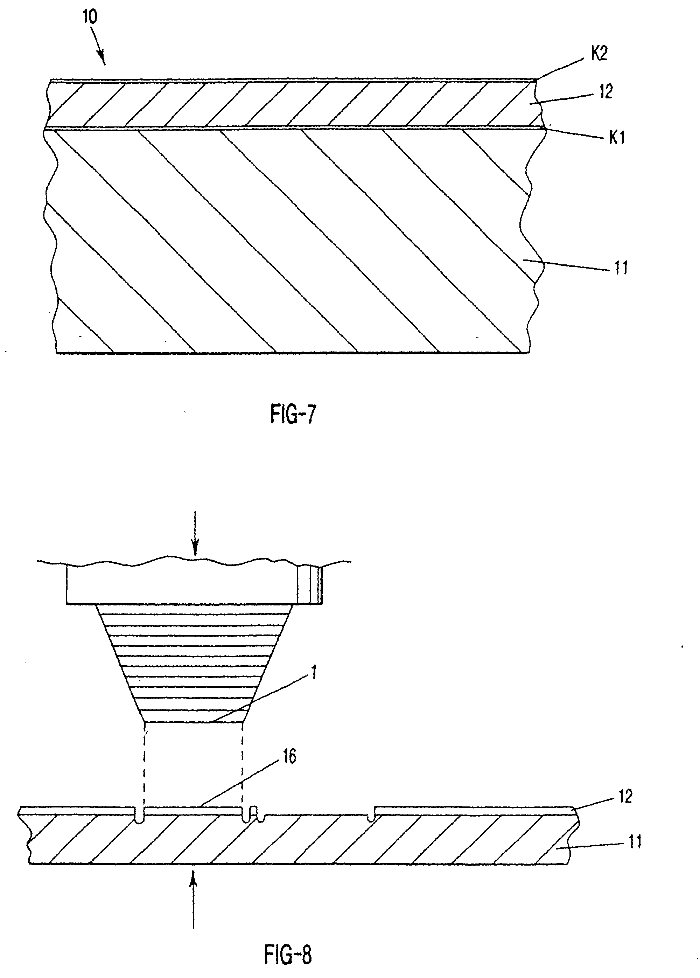

Die Ausführungsform in den Fig. 7 und 8 stellt eine Alternative zu dem Lötverfahren dar. Statt der beiden Lötschichten L1 und L2 sind dort die beiden Komponenten K1 sowie K2 eines 2-Komponenten-Klebers vorgesehen. Die beiden Kleberkomponenten K1, K2 haben dabei im Ausgangszustand eine gewisse Klebneigung, so daß das Körpermaterial 12 durch die Komponente K1 relativ fest mit dem Trägermaterial 11 verbunden ist. Die eigentliche Klebefestigkeit wird jedoch erst erreicht, wenn die Komponente K1 mit der Komponente K2 in Berührung kommt. Durch Anpressen einer neuen Schicht, auf deren Oberseite die Komponente K2 vorhanden ist, kann eine chemische Reaktion der beiden Komponenten stattfinden (durch das Ablösen vom Trägermaterial 11 befindet sich auf der Unterseite der bereits aufgebauten Geometrie die Kleberkomponente K1), wodurch eine feste Verbindung zwischen bereits existierender Geometrie und neuer Schicht erreicht wird. Dadurch wird ein Ablösen vom Trägermaterial 11 möglich, da die chemisch ausreagierten Kleberkomponenten K1, K2 eine wesentlich höhere Festigkeit haben als die Kleberkomponente K1. Der gesamte Prozeß wird durch eine erhöhte Temperatur unterstützt, die jedoch nur zeitweise, d.h. während des Reaktionsprozesses der beiden Kleberkomponenten K1 und K2 sowie zum Ablösen des Körperelements 16 vom Trägermaterial 11 wirkt. Durch die erhöhte Temperatur verringert sich die Klebneigung der Komponente K1, so daß das Ablösen vom Trägermaterial 11 erleichtert wird. Durch die erhöhte Temperatur wird weiterhin die Kteberaktion (Aushärteprozeß) beschleunigt. Die Temperaturaufprägung kann ähnlich dem Lotvorgang durch eine beheizbare Platte (Tisch) erfolgen, die nur zeitweise aktiv ist.

Schließlich sei noch ein Anlagenkonzept erwähnt, welches nicht in den Zeichnungen dargestellt ist. Dabei wird eine zweite Bandanlage verwendet, ähnlich der kleinen Bandanlage in der Zusatzbandanlage 2' zur Erzeugung der ersten Konturschicht. Dabei ist die Metallfolie beidseitig mit Lot beschichtet (hoch- und niedriegschmelzend). Das Trägermaterial wird als einschichtiges Band gefahren. Die Konturschichten werden mit dem Laser zunächst an das Trägermaterial angelötet und dadurch fixiert, anschließend ausgeschnitten und ebenfalls durch das Trägerband in den Lotofen transportiert und dem Geometrieaufbau zugeführt.

### Bezugszeichenliste

- 1: metallischer Körper
- 2: Ausschneidestation
- 2': Zusatzbandanlage
- 3: Befestigungsstation
- 4: Auflagetisch
- 5: Laser-Gravierer
- 6: Auflagetisch
- 7: Lotofen
- 8: Träger
- 9: Band
- 10: Grundmaterial
- 11: Trägermaterial
- 12: Körpermaterial
- 13: Vorratsrolle
- 14: Rolle
- 15: Schnitt
- 16: Körperelement
- 17: Band

- K1: Kleberkomponente
- K2: Kleberkomponente

- L1: erste, niedrigschmelzende Lotschicht
- L2: zweite, hochschmelzende Lotschicht

## Patentansprüche

1. Verfahren zum Herstellen eines metallischen oder keramischen Körpers (1),
bei dem der Körper (1) aus flächigen Körperelementen (16) schichtweise aufgebaut wird,
wobei von einem Grundmaterial (10) ausgegangen wird, welches ein Trägermaterial (11) mit darauf lösbar befestigtem Körpermaterial (12) aufweist, und
wobei die flächigen Körperelemente (16) zunächst aus dem Körpermaterial (12) des Grundmaterials (10) ausgeschnitten und anschließend durch einen physikalischen oder chemischen Prozeß mit der zuletzt aufgebrachten Schicht verbunden werden und schließlich Trägermaterial (11) und Körperelement (16) voneinander gelöst werden,
**dadurch gekennzeichnet,**
**daß** das Körpermaterial (12) des Grundmaterials (10) auf der Oberseite mit einer Beschichtung versehen ist, mittels welcher die Körperelemente (16) mit der zuletzt aufgebrachten Schicht verbunden werden.

2. Verfahren nach Anspruch 1,
**dadurch gekennzeichnet,**
**daß** das flächige Körperelement (16) mittels einer ersten Lotschicht (L1) auf dem Trägermaterial (11) befestigt ist sowie auf der Oberseite eine zweite, bezüglich der ersten Lotschicht (L1) höherschmelzende Lotschicht (L2) aufweist und
**daß** für den physikalischen Verbindungsprozeß zunächst das flächige Körperelement (16) mit seiner zweiten Lotschicht (L2) in Kontakt mit der zuletzt aufgebrachten Schicht des Körpers (1) gebracht und eine Erwärmung über die Schmelztemperatur der zweiten Lotschicht (L2) hinaus durchgeführt wird und
**daß** schließlich eine Abkühlung auf eine Temperatur zwischen der Schmelztemperatur der zweiten Lotschicht (L2) und der Schmelztemperatur der ersten Lotschicht (L1) durchgeführt und das flächige Körperelement (16) vom Trägermaterial (11) abgelöst wird.

3. Verfahren nach Anspruch 1,
**dadurch gekennzeichnet,**
**daß** das flächige Körperelement (16) mittels wenigstens einer, ersten Komponente (K1) eines Mehr-Komponenten-Klebers auf dem Trägermaterial (11) befestigt ist sowie auf der Oberseite wenigstens eine weitere, zweite Komponente (K2) des Mehr-Komponenten-Klebers aufweist und
**daß** für den chemischen Verbindungsprozeß die Oberseite des flächigen Körperelements (16) mit ihrer/ihren Komponente/n (K2) des Mehr-Komponenten-Klebers in Kontakt mit der/den noch anhaftenden ersten Komponente/n (K1) des Mehr-Komponenten-Klebers aus der vorangegangenen Beschichtung gebracht wird und anschließend die Komponenten (K1,K2) zu einer festen Verbindung miteinander chemisch reagieren und
**daß** schließlich das flächige Körperelement von dem Trägermaterial (11) abgelöst wird.

4. Verfahren nach Anspruch 3,
**dadurch gekennzeichnet,**
**daß** zusätzlich Wärme zugeführt wird.

5. Verfahren nach einem der vorhergehenden Ansprüche,
**dadurch gekennzeichnet,**
**daß** der Körper (1) mit unterschiedlich dicken flächigen Körperelementen (16) aufgebaut wird.

6. Verfahren nach einem der vorhergehenden Ansprüche,
**dadurch gekennzeichnet,**
**daß** die flächigen Körperelemente (16) mittels Laser ausgeschnitten werden.

7. Verfahren nach einem der vorhergehenden Ansprüche,
**dadurch gekennzeichnet,**
**daß** bei Herstellungsbeginn des Körpers (1) oder bei einer Konturänderung des Körpers (1) parallel zum zuletzt aufgetragenen Körperelement (16) zunächst aus dem Grundmaterial (10) das zweitnächste flächige Körperelement (16) ausgeschnitten wird und
**daß** anschließend auf dieses Grundmaterial (10) ein weiteres Körpermaterial (12) mit oberseitigem Verbindungsmaterial aufgebracht und daraus das erstnächste flächige Körperelement (16) ausgeschnitten wird.

8. Verfahren nach einem der vorhergehenden Ansprüche,
**dadurch gekennzeichnet,**
**daß** das Körpermaterial (12) benachbart zum Schnitt (15) oberflächenmäßig teilweise oder ganz abgetragen wird.

9. Verfahren nach einem der Ansprüche 1 bis 8,
**dadurch gekennzeichnet,**
**daß** das Grundmaterial (10) als von einer Vorratsrolle (13) abwickelbares Bandmaterial ausgebildet ist.

10. Verfahren nach einem der Ansprüche 1 bis 8,
**dadurch gekennzeichnet,**
**daß** das Grundmaterial (10) als Einzelplatte ausgebildet ist.

## Claims

1. Process for production of a metallic or ceramic body (1) in which the body is constructed in layers from flat body elements (16), where the starting material is a base material (10) which has a carrier material (11) with body material (12) releasably attached thereon, and where the flat body elements (16) are first cut out of the body material (12) of the base material (10) and then connected by a physical or chemical process with the last layer applied, and finally the carrier material (11) and body element (16) are separated from each other, **characterised in that** the body material (12) of the base material (10) has on the top a coating by means of which the body elements (16) are connected with the last layer applied.

2. Process according to claim 1, **characterised in that** the flat body element (16) is attached to the carrier material (12) by means of a first solder layer (L1) and on the top has a second solder layer (L2) melting at a higher temperature than the first solder layer (L1), and that for the physical connection process first the flat body element (16) with its second solder layer (L2) is brought into contact with the last layer of the body (1) applied and heating is applied above the melt temperature of the second solder layer (L2), and that finally a cooling takes place to a temperature between the melt temperature of the second solder layer (L2) and the melt temperature of the first solder layer (L1) and the flat body element (16) is separated from the carrier material (11).

3. Process according to claim 1, **characterised in that** the flat body element (16) is attached to the carrier material (11) by means of at least one first component (K1) of a multi-component adhesive and on the top has a further second component (K2) of the multi-component adhesive, and that for the chemical connection process the top of the flat body element (16) with its component(s) (K2) of the multi-component adhesive is brought into contact with the still adhering first component(s) (K1) of the multi-component adhesive from the previous coating and then the components (K1, K2) react chemically together to create a firm connection, and that finally the flat body element is separated from the carrier material (11).

4. Process according to claim 3, **characterised in that** additional heat is supplied.

5. Process according to any of the previous claims, **characterised in that** the body is constructed with flat body elements (16) of different thickness.

6. Process according to any of the previous claims, **characterised in that** the flat body elements (16) are cut out by laser.

7. Process according to any of the previous claims, **characterised in that** at the start of production of the body (1) or on a contour change of the body (1) parallel to the last body element (16) applied, first the second-next flat body element (16) is cut out of the base material (10) and then on this base material (10) is placed a further body material (12) with connecting material on the top, and from this the first-next flat body element (16) is cut out.

8. Process according to any of the previous claims, **characterised in that** the body material (12) adjacent to the cut (15) is removed superficially partly or fully.

9. Process according to any of claims 1 to 8, **characterised in that** the base material (10) is formed as a strip material which can be unwound from a storage roll (13).

10. Process according to any of claims 1 to 8, **characterised in that** the base material (10) is formed as a single plate.

## Revendications

1. Procédé de fabrication d'un corps métallique ou céramique (1),
selon lequel le corps (1) est structuré en couches constituées d'éléments de corps plans (16),
en partant d'un matériau de base (10) qui présente un matériau porteur (11) sur lequel un matériau de corps (12) est fixé de manière amovible,
les éléments de corps plans (16) étant d'abord découpés dans le matériau de corps (12) du matériau de base (10) puis assemblés par un processus physique ou chimique à la dernière couche apposée, et enfin le matériau porteur (11) et l'élément de corps (16) étant détachés l'un de l'autre,
**caractérisé en ce que** le matériau de corps (12) du matériau de base (10) est pourvu sur sa face supérieure d'un revêtement au moyen duquel les éléments de corps (16) sont assemblés à la dernière couche apposée.

2. Procédé selon la revendication 1, **caractérisé en ce que** l'élément de corps plan (16) est fixé au moyen d'une première couche (L1) de métal d'apport de brasage sur le matériau porteur (11), et présente sur sa face supérieure une deuxième couche (L2) de métal d'apport de brasage, de plus haut point de fusion que la première couche (L1) de métal d'apport de brasage,
et **en ce que**, pour le processus d'assemblage physique, l'élément de corps plan (16) est d'abord amené en contact par sa deuxième couche (L2) de métal d'apport de brasage avec la dernière couche apposée du corps (1), et on effectue un échauffement au-delà de la température de fusion de la deuxième couche (L2) de métal d'apport de brasage,
et **en ce qu'**on effectue enfin un refroidissement à une température située entre la température de fusion de la deuxième couche (L2) de métal d'apport de brasage et la température de fusion de la première couche (L1) de métal d'apport de brasage, et l'élément de corps plan (16) est détaché du matériau porteur (11).

3. Procédé selon la revendication 1, **caractérisé en ce que** l'élément de corps plan (16) est fixé sur le matériau porteur (11) au moyen d'au moins un premier composant (K1) d'une colle à plusieurs composants, et présente sur sa face supérieure au moins un autre deuxième composant (K2) de la colle à plusieurs composants,
et **en ce que**, pour le processus d'assemblage chimique, la face supérieure de l'élément de corps plan (16) est amenée en contact par son/ses composants (K2) de la colle à plusieurs composants avec le/les premiers composants (K1) encore adhérents de la colle à plusieurs composants du revêtement précédent, puis les composants (K1, K2) réagissent chimiquement entre eux pour former un assemblage fixe,
**et en ce que** l'élément de corps plan est enfin détaché du matériau porteur (11).

4. Procédé selon la revendication 3, **caractérisé en ce qu'**on apporte en plus de la chaleur.

5. Procédé selon l'une quelconque des revendications précédentes, **caractérisé en ce que** le corps (1) est constitué d'éléments de corps plans (16) de différentes épaisseurs.

6. Procédé selon l'une quelconque des revendications précédentes, **caractérisé en ce que** les éléments de corps plans (16) sont découpés au laser.

7. Procédé selon l'une quelconque des revendications précédentes, **caractérisé en ce que**, au début de la fabrication du corps (1) ou lors d'une modification du contour du corps (1) parallèlement au dernier élément de corps (16) apposé, on découpe d'abord dans le matériau de base (10) le deuxième élément de corps plan (16) le plus proche, et **en ce qu'**on appose ensuite sur ce matériau de base (10) un autre matériau de corps (12) pourvu de matériau d'assemblage sur sa face supérieure, et on y découpe le premier élément de corps plan (16) le plus proche.

8. Procédé selon l'une quelconque des revendications précédentes, **caractérisé en ce que** le matériau de corps (12) est partiellement ou totalement retiré en surface au voisinage de la coupe (15).

9. Procédé selon l'une quelconque des revendications 1 à 8, **caractérisé en ce que** le matériau de base (10) est réalisé sous forme de matériau en bande pouvant être déroulé d'une bobine d'alimentation (13).

10. Procédé selon l'une quelconque des revendications 1 à 8, **caractérisé en ce que** le matériau de base (10) est réalisé sous forme de plaque individuelle.
